(19) **Europäisches Patentamt**
**European Patent Office**
**Office européen des brevets**

(11) **EP 2 244 292 A1**

(12) **EUROPEAN PATENT APPLICATION**

(43) Date of publication:
**27.10.2010 Bulletin 2010/43**

(51) Int Cl.:
**H01L 27/02** $^{(2006.01)}$    **H03K 19/003** $^{(2006.01)}$

(21) Application number: **09290291.5**

(22) Date of filing: **20.04.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(71) Applicant: **NXP B.V.**
**5656 AG Eindhoven (NL)**

(72) Inventors:
• **Scott, Ruth**
**Crolles (FR)**

• **Negoi, Andy**
**Crolles (FR)**

(74) Representative: **Schouten, Marcus Maria et al**
**NXP B.V.**
**IP & L Department**
**High Tech Campus 32**
**5656 AE Eindhoven (NL)**

Remarks:
Amended claims in accordance with Rule 137(2) EPC.

(54) **Integrated circuit with ESD protection unit**

(57)    An integrated circuit is provided which comprises an integrated circuit core unit (ICC), a plurality of input-output cells (IOC) coupled to the integrated circuit core unit (ICC) for protecting the core unit (ICC) from electrostatic discharges and a plurality of trigger units (TU). The integrated circuit furthermore comprises a first and second supply line (OVSS, OVDD), a first line (ESD_boost) coupled to the trigger unit (TU), a second line (ESD_trigger) coupled between the trigger unit (TU) and the at least one of the input-output cells (IOC), and a third line (esd_trigger_pmos). Each input-output cell (IOC) is coupled between the first and second supply line (OVSS, OVDD) and comprises a clamp transistor unit (CTN, CTP) coupled between the first and second supply line (OVSS, OVDD). The clamp transistor unit (CTN, CTP) can be implemented as a stacked complementary MOS unit with a series arrangement of a PMOS and a NMOS transistor. The trigger unit (TU) is coupled to the clamp transistor unit (CTN, CTP) via the second line (ESD_trigger). The trigger unit (TU) triggers the clamp transistor (CTN, CTP) via the second line (ESD_trigger) if an electrostatic discharge is detected on the first line (OVSS).

Fig.3

EP 2 244 292 A1

**Description**

FIELD OF THE INVENTION

The invention relates to an integrated circuit with an ESD protection unit.

BACKGROUND OF THE INVENTION

In modern CMOS technologies the gate oxides of MOS transistors are very thin while the MOS transistors may have an operating voltage Vdd in the range of 1V. An integrated circuit typically comprises an IC core with a plurality of MOS transistors which are very fragile. High voltages which are built up because of electrostatic charging in the manufacturing chain, at the chip assembly or during the application may destroy the entire integrated circuit or at least parts thereof. The electrostatic discharge ESD problems during the manufacturing can therefore lead to a very low manufacturing yield. To protect the IC core a plurality of input output IO cells are organized or arranged in a ring IOR around the IC core. These IO cells are used for a Vdd level shifting for noise immunity. Furthermore, these IO cells are used for the ESD protection to protect the core from ESD shocks occurring at the pins of the IC.

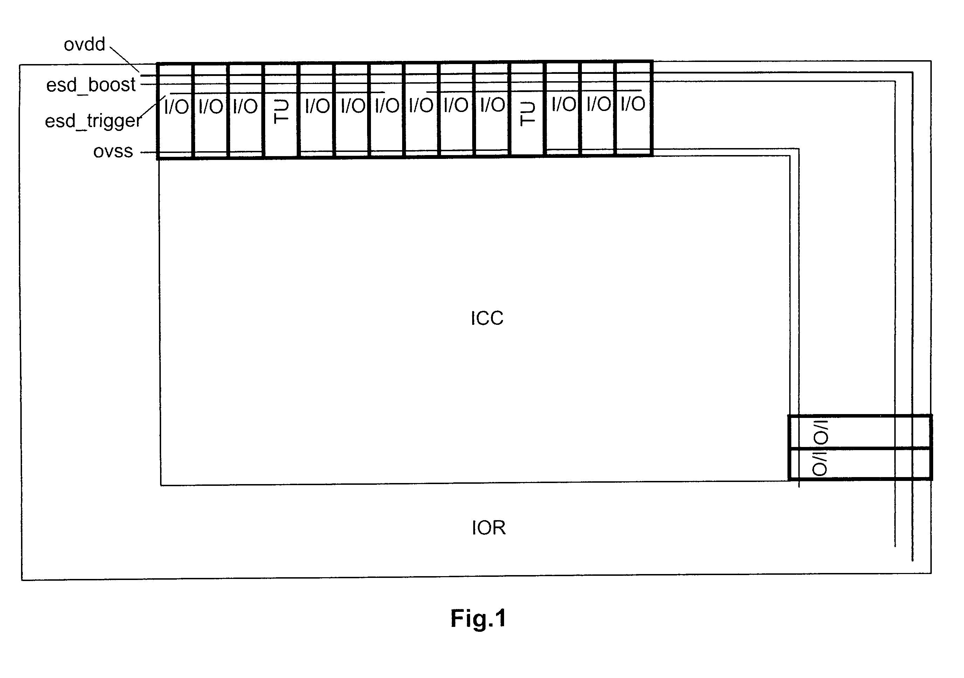

Fig. 1 shows a schematic representation of an integrated circuit with an IO ring of IO cells. The IO cells arranged around an IC core will be connected between the output supply voltage ovdd and the supply voltage ovss. The IO cells may be able to perform an ESD protection. Several IO cells may share a trigger unit TU for triggering the ESD protection. The trigger unit TU is coupled to several IO cells by means of an ESD_trigger rail. The IO cells and the trigger units are also coupled to an esd_boost rail.

In order to take care of the electrostatic discharge ESD problem each IO cell comprises a large clamp transistor (generally a NMOS transistor). This clamp transistor is arranged to provide an alternative and low resistive path when the clamp transistor is activated. Therefore, when the clamp transistor is activated or triggered by the trigger circuit, the supply lines OVDD and the supply line OVSS are short circuited such that the ESD charge does not pass through the active circuitry in the IC core but passes through the clamp transistor.

However, on the other hand if a very conductive current path is created (by the clamp transistor) which allows a current flow of about 4A in an ESD event, a very high current capability for the ESD protection network must be ensured. The provision of a MOS clamp transistor is advantageous as the ESD behavior can be easily simulated and the design of the IO cells can be optimized based on the simulation results. The metal rail resistances and the high current path are important for manufacturing technologies with a gate length of below 100nm (i.e. for CMOS090, CMOS065, CMOS045 and below). The speed of a reaction to the trigger unit (which produces a trigger pulse to apply on the gate of the NMOS ESD clamps in each IO cell if a very fast rising edge is detected, on the rail ESD_boost) can be improved in a distributed and boosted ESD network.

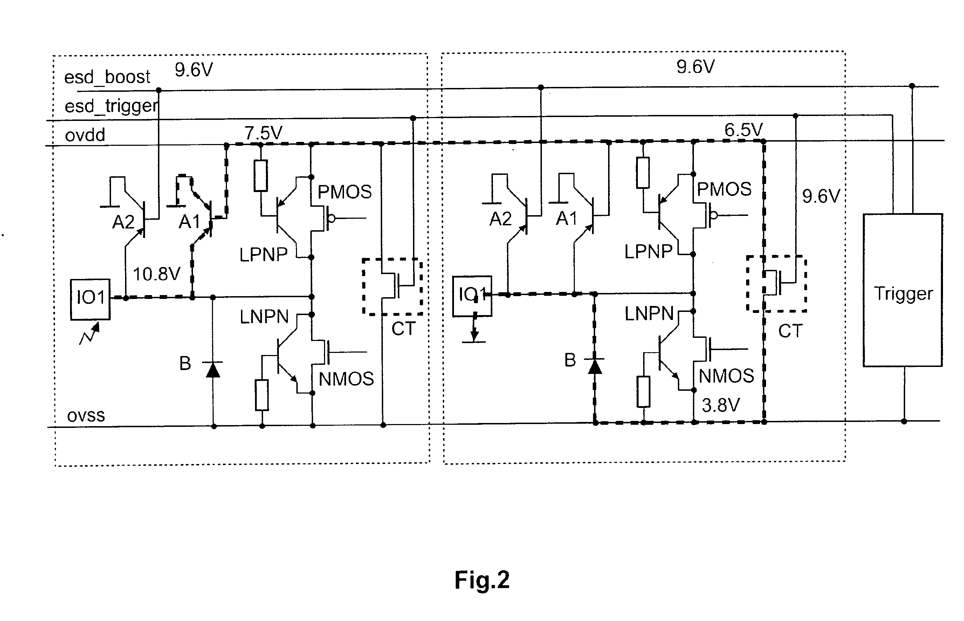

Fig. 2 shows a more detailed circuit diagram of two IO cells according to Fig. 1. The IO cell receives the supply voltage metal rails OVDD, OVSS, a line for receiving the trigger signal ESD_trigger from the trigger unit TU and a line ESD_boost on which a very fast rising edge is to be detected, e.g. by the trigger unit TU. Each IO cell IO comprises a clamp transistor CT which is coupled between the metal rail supply voltages OVDD, OVSS. The gate of the clamp transistor CT is coupled to the output esd_trigger from the trigger unit TU. Furthermore, each IO cell IO comprises a PMOS transistor coupled in series with a NMOS transistor. A first bipolar transistor LPNP is coupled in parallel to the PMOS transistor. A second bipolar transistor LNPN is coupled in parallel to the NMOS transistor. Furthermore, a first and second diode A1, A2 and a third diode B are also provided.

The PMOS and the NMOS transistors constitute the output buffer transistors. The bipolar transistors LNPN, LPNP constitute the lateral bipolar transistors which are inherent to a MOS structure. If an ESD event occurs and the IO cells are not protected, then the output transistors would be destroyed due to the high current which flow through their associated bipolar transistors LNPN, LPNP. It should be noted that the drains of the output buffer transistors PMOS, NMOS are directly tied to the pad.

The metal rails OVDD and OVSS constitute to low resistive metal rails which may carry all the ESD transient current. Furthermore, a ESD_boost rail is connected via the second diode A2 to the pad. The pad corresponds to the rail which does not carry a lot of current but serves to supply the remote trigger circuit. The diodes A 1 and B are carrying all the ESD current and are closing the loop. The clamp transistor CT is then driven by the trigger unit TU via the rail ESD_trigger.

The above trigger units TU can be implemented for example as a so-called slew-rate detector with a monostable trigger pulse generator as described by Michael Stockinger, James W. Miller et al. "Boosted and distributed rail clamp networks for ESD protection in advanced CMOS technologies", Proc. of EOS/ESD Symposium 2003.

If a very fast rising pulse (for example 4V in less than 10ns) occurs on the metal rail ESD_boost, the trigger unit TU will immediately fire a pulse for a period of about $1\mu s$, which corresponds to the time in which ESD event is considered to be finished and all electrostatic charges have been evacuated. However, if the rise time on the metal rail ESD_boost is longer which can occur during normal power-up, no pulse will be generated by the trigger unit. The energy which is required by the trigger unit to drive the clamp transistors via the ESD trigger metal rail is provided from the energy of the ESD as the trigger unit TU has to function without a supply voltage.

As each IO cell comprises a NMOS clamp transistor, these clamp transistors are distributed and require a current depending on the their $V_{GS}$ drive. The driving voltage $V_{GS}$ may vary due to a voltage drop along the rail OVSS. Therefore, also the trigger units TU must be distributed among the IO cells to ensure a sufficient driving strength.

In such IO cells with the NMOS clamp transistor the static leakage current may become a problem if a constant $V_{ds}$ is applied across the NMOS clamp transistor. As shown in Fig. 2, the clamp transistor is connected between the two supply lines, i.e. the clamp transistor is coupled between the highest voltages on the chip. Therefore, the static leakage currents are preferably avoided.

SUMMARY OF THE INVENTION

It is therefore an object of the invention to provide an integrated circuit with an improved ESD protection.

This object is solved by an integrated circuit according to claim 1.

Therefore, an integrated circuit is provided which comprises an integrated circuit core unit, a plurality of input-output cells coupled to the integrated circuit core unit for protecting the core unit from electrostatic discharges and a plurality of trigger units. The integrated circuit furthermore comprises a first and second supply line, a first line coupled to the trigger unit, a second line coupled between the trigger unit and the at least one of the input-output cells and a third line. Each input-output cell is coupled between the first and second supply line and comprises a clamp transistor unit coupled between the first and second supply line. The clamp transistor unit can be implemented as a stacked complementary MOS unit with a series arrangement of a PMOS and a NMOS transistor. The trigger unit is coupled to the clamp transistor unit via the second line. The trigger unit triggers the clamp transistor via the second line if an electrostatic discharge is detected on the first line.

According to an aspect of the invention, a fourth line is coupled to the trigger unit.

According to still a further aspect of the invention, the drain of the NMOS transistor is coupled to the second supply line, the gate of the NMOS transistor is coupled to ground, the drain of the PMOS transistor is coupled to ground and the gate of the PMOS transistor is coupled to the second supply line.

According to a further aspect of the invention, the gate source voltage of the NMOS transistor corresponds to -0,5 times the supply voltage and the gate source voltage of the PMOS transistor corresponds to 0,5 times the supply voltage.

The invention relates to the idea to provide a stacked complementary MOS structure instead of a single gate clamp transistor or a stacked NMOS transistor unit. With this stacked complementary MOS structure, the leakage current can be significantly reduced. The stacked complementary MOS structure may comprise a series arrangement of a PMOS and a NMOS transistor, wherein their source are coupled to each other via an intermediate note. The intermediate node is floating at an intermediate potential between ovdd and ovss. The gate of the NMOS transistor is controlled by the control voltage esd_trigger. In normal operation, the control voltage esd_trigger is triggered by means of the trigger unit to the supply voltage ovss. The PMOS transistor in the series arrangement of the stacked MOS structure is self-biased at a potential of ovdd/2 through the voltage divider of the NMOS and PMOS transistor. The gate of the PMOS transistor is controlled by a control voltage esd_trigger_pmos. This second control voltage is tied to ovdd by the trigger unit in normal operation.

The major disadvantage of a complementary stacked clamp transistor unit comprising a NMOS transistor and a PMOS transistor is the area penalty as compared to a single clamp transistor as described according to Fig. 2. However, this area penalty can be reduced by boosting the NMOS and PMOS transistor gates in the inverter stack and by using special optimized devices like power switches for the clamp transistors.

Further aspects of the invention are defined in the dependent claims.

BRIEF DESCRIPTION OF THE DRAWINGS

The advantages and embodiments of the invention will now be described in more detail with reference to the Figures.

Fig. 1 shows a schematic representation of an integrated circuit according to the prior art,
Fig. 2 shows a detailed schematic diagram of two IO cells according to fig. 1,
Fig. 3 shows a schematic diagram of an IO cell and a trigger unit according to a first embodiment,
Fig. 4 shows a schematic diagram of the clamp transistor unit according to the first embodiment, and
Fig. 5 shows a graph depicting the static leakage current for several clamp transistor topologies.

DETAILED DESCRIPTION OF EMBODIMENTS

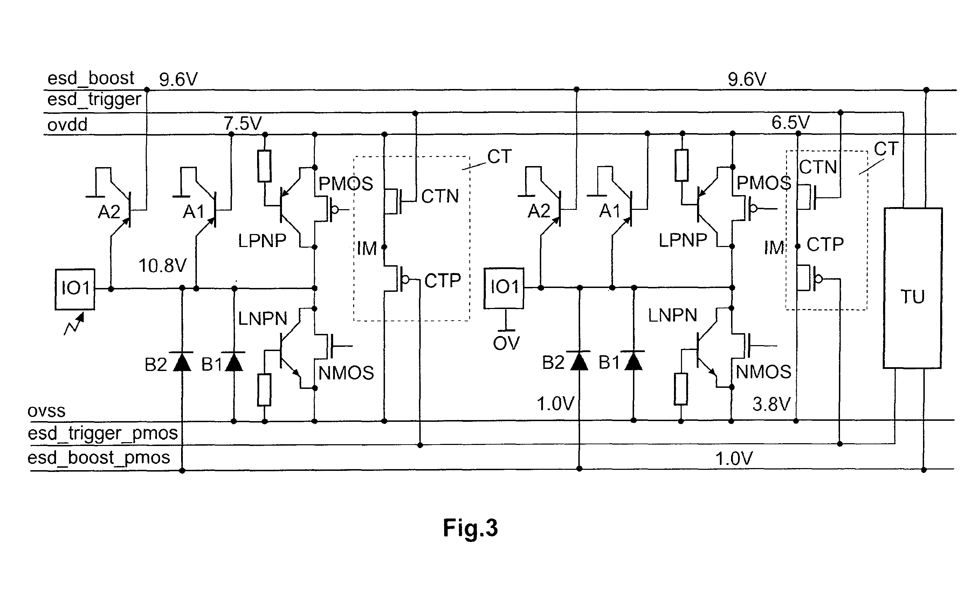

Fig. 3 shows a detailed circuit diagram of two IO cells according to a first embodiment. The circuit diagram according to the first embodiment is based on the circuit diagram according to Fig. 2. However, additionally, a PMOS ESD trigger esd_trigger_pmos line and a PMOS ESD boost line esd_boost_pmos line is provided. Each of these two lines are coupled to the trigger unit TU. Furthermore, in addition, a second diode B2 is provided and is coupled between the ESD boost PMOS line esd_boost_pmos and an intermediate node between the PMOS and the NMOS transistor. Moreover, a PMOS clamp transistor CTP is coupled in series with the NMOS clamp transistor CTN. The series arrangement of the NMOS and PMOS clamp transistor is coupled between the two supply lines ovdd, ovss. The sources of the two clamp transistors are coupled via an intermediate node IM. The PMOS clamp transistor CTP is coupled between the intermediate node IM and the supply line ovss. The gate of the PMOS clamp transistor CTP is coupled to the PMOS ESD trigger line esd_trigger_pmos. The NMOS clamp transistor CTN is coupled between the supply line ovdd and the intermediate node IM. The gate of the NMOS clamp transistor CTN is coupled to the ESD trigger line esd_trigger, which in turn is also coupled to the trigger unit TU.

According to the first embodiment, a boosted NMOS/PMOS stacked rail clamp is used. The PMOS clamp transistor CTP is boosted in a complementary way to the NMOS transistor. To achieve this, a small diode B2 is connected between the IO input/output pad and a special rail PMOS ESD boost esd_boost_pmos. Preferably, this rail can be implemented rather small as it does not have to be able to supply a significant amount of power. Therefore, the PMOS ESD boost rail esd_boost_pmos is closer to 0V than the supply voltage potential ovss. When the potential of the PMOS ESD boost rail esd_boost_pmos is applied, a boosting effect can be realized.

In case of a normal operation (no ESD event, OVDD is at 2V, OVSS is at 0V) the potential on the line esd_boost_pmos is set at OVSS and the potential on the line esd_trigger_pmos is at the highest potential which is OVDD. When the line OVDD is raising very fast due tu an ESD event, the large current of about 4A is flowing through the diodes A I, the line OVDD, the clamps, the line OVSS and the diodes B1. Far away from the point where the shock is applied, the potential of OVDD is no more zero since there is voltage drop due to the line resistance. The meaning of a boosted network is that a narrow line in which there is no current flow transmits the potential of zero volts to the trigger circuit unit which is the closest to the clamps. That trigger circuit will set the esd_trigger_pmos signal which controls the gate of the PMOS part of the clamp, to the same potential as esd_boost_pmos, so to zero volts for the period of time of about one microsecond.

It should be noted that the trigger unit TU is used to connect the ESD boost rails esd_boost_pmos and the PMOS ESD trigger rails esd_trigger_pmos in case of an ESD event. Here, it should also be noted that the gate source voltage Vgs is larger and also that the drive strength is higher for a given transistor size such that the size of the transistors can also be reduced.

The esd_boost_pmos rail line supplies the trigger circuit TU with the real zero volts skipping the voltage drop on the OVSS line due to its limited resistance, because the esd_boost_pmos does not carry any large current.

In order to reduce the area penalty introduced by using the complementary stacked clamp transistors, special switching devices can be used in this complementary stacked clamp transistor unit. These special switching devices are typically used to switch off certain blocks of a chip when this block is not in use. The special devices are typically designed to reduce the off-state static leakage current. Therefore, they are optimized for a maximum $I_{on}/I_{off}$ ratio. Furthermore, the special switching devices can be more area compact than standard PMOS devices. Accordingly, by the use of the special switching devices, the overall area impact imposed by the stacked network can be reduced.

The special switching devices can be MOS devices which are optimized for low leakage through special implants and which are designed to be smaller in size. This area saving could be done for example for a NMOS transistor by driving the gate at a negative potential with regard to its source and bulk, in which mode it is proven that the leakage is much smaller. For a PMOS, in the off state, raising the gate potential above the source and NWELL will make it less leaky. However the use of these kind of devices represent only a possible embodiment and this invention will work as well with standard transistors.

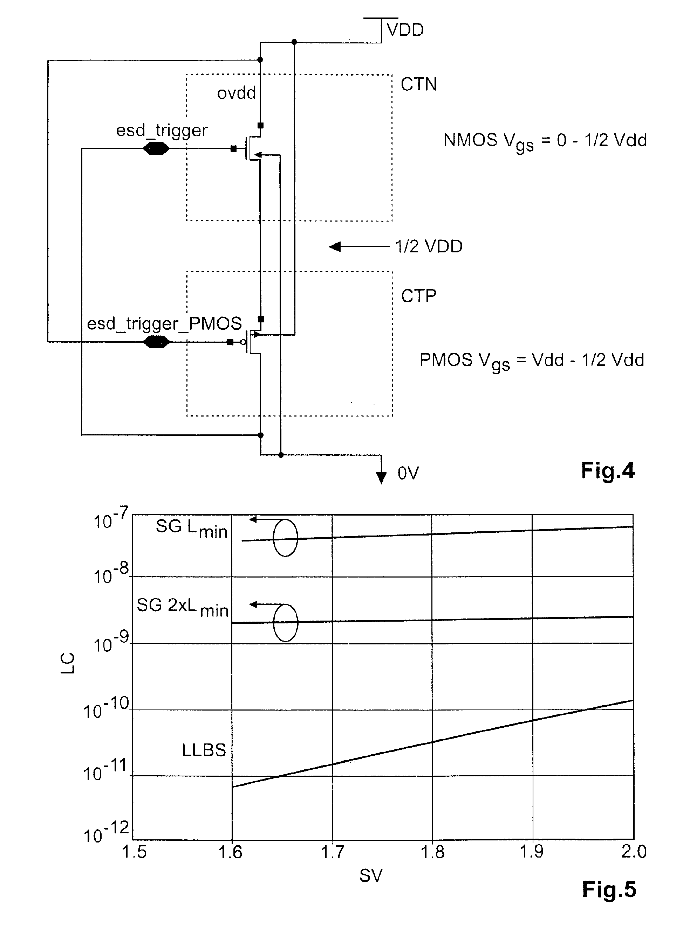

Fig. 4 shows a schematic diagram of the clamp transistor unit according to the first embodiment. Here, the series arrangement of the NMOS clamp transistor CTN and the PMOS clamp transistor CTP is depicted. In order to improve the performance of the series arrangement of the two transistors, the connection should be exactly opposite of that of a usual CMOS inverter. Accordingly, the drain of the NMOS transistor is connected to VDD and the source of the PMOS transistor is connected to ground GND. During a normal operation, the series arrangement will not conduct current except for a leakage current. Hence, the gate of the PMOS transistor is connected to VDD and the gate of the NMOS transistor is connected to ground. It should be noted that this statement is made for illustrating the principles of the invention and may be oversimplified. It may be required to provide a mechanism to control the voltage on the trigger and boost rails during normal operation. For example, with an appropriate switching circuit, the esd_trigger rail would be pulled down to 0V and the PMOS ESD trigger rail esd_trigger_pmos would be pulled up to the supply voltage VDD during a normal operation.

With the stacked series arrangement according to Fig. 4, the gate source voltages $V_{gs}$ of the two transistors in the stack are chosen such that the leakage current can be significantly reduced.

Accordingly,

$$\text{NMOS } V_{gs} = -\tfrac{1}{2} * Vdd$$

$$\text{PMOS } V_{gs} = \tfrac{1}{2} * Vdd$$

Hence, with an appropriate biasing, the leakage current can be significantly reduced as compared to an off-state biasing with a gate source voltage $V_{gs}$ = 0V.

Fig. 5 shows a graph depicting a comparison of several static leakage currents LC over the supply voltage SV. Here, a specific example for an advance CMOS process is depicted. The same total width was used for each clamp topology. It should be noted that at 1,8V which corresponds to the nominal supply voltage the difference between the clamp with $2xL_{min}$ and the topology proposed by this invention is nearly two orders of magnitude.

In Fig. 5, the graph SG [$L_{min}$] corresponds to a single gate clamp with a minimum gate length. The line SG2 x $L_{min}$ corresponds to a single gate clamp with two times the minimum gate length and the line LLBS corresponds to a low leakage boosted stacked clamp transistor according to Fig. 3 and 4.

The series arrangement of the clamp transistors according to the first embodiment can be implemented in input/output cells of an integrated circuit. As these clamp transistor arrangements are very repetitive as they are provided in each IO cell, the layout of the integrated circuit should provide a means to detect the presence thereof.

It should be noted that the principles of the present invention relate to a topology with a reduced static leakage current in a rail-based ESD protection network. The circuits according to the invention can be implemented in all general purpose IC as well as in special IO types for commercial products used in consumer electronics, computers, mobile phones, set-top-boxes, etc. If the principles of the invention are used in mobile applications, due to the reduced static leakage current the current consumption will be reduced enabling a longer battery life.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. In the device claim enumerating several means, several of these means can be embodied by one and the same item of hardware. The mere fact that certain measures are recited in mutually different dependent claims does not indicate that a combination of these measures cannot be used to advantage.

Furthermore, any reference signs in the claims shall not be constrained as limiting the scope of the claims.

**Claims**

1. Integrated circuit, comprising:

    an integrated circuit core unit (ICC), a plurality of input-output cells (IOC) coupled to the integrated circuit core unit (ICC) for protecting the core unit (ICC) from electrostatic discharges, a plurality of trigger units (TU), a first supply line (OVSS), a second supply line (OVDD), a first line (ESD_boost) coupled to the trigger unit (TU), a second line (ESD_trigger) coupled between a trigger unit (TU) and at least one of the input-output cells (IOC),

    wherein each input-output cell (IOC) is coupled between the first and second supply line (OVSS, OVDD) and comprises a clamp transistor unit (CTN, CTP) coupled between the first and second supply line (OVSS, OVDD), a third line (esd_trigger_pmos), wherein the clamp transistor unit (CTN, CTP) comprises a series arrangement of a NMOS transistor (CTN) and a PMOS transistor (CTP), wherein the trigger unit (TU) is coupled to the gate of the NMOS transistor (CTN) in the clamp transistor unit (CTN, CTP) via the second line (ESD_trigger), wherein the trigger unit (TU) is coupled to the gate of the PMOS transistor (CTP) in the clamp transistor unit (CTN, CTP) via the third line (esd_trigger_pmos), and wherein the trigger unit (TU) is arranged to trigger the clamp transistor unit (CTN, CTP) via the second and third line (ESD_trigger esd_trigger_pmos) if an electrostatic discharge event is detected on the first line (OVSS).

2. Integrated circuit according to claim 1, furthermore comprising:

    a fourth line (esd_boost_pmos), which is coupled to the trigger unit (TU).

3. Integrated circuit according to claim 1 or 2, wherein the drain of the NMOS transistor (CTN) is coupled to the second supply line (OVDD), wherein the gate of the NMOS transistor (CTN) is coupled to ground, wherein the drain of the PMOS transistor (CTP) is coupled to ground, and wherein the gate of the PMOS transistor (CTP) is coupled to the second supply line (OVDD).

4. Integrated circuit according to any one of the claims 1 to 3, wherein the gate source voltage of the NMOS transistor (CTN) corresponds to -0,5 times the supply voltage (VDD), wherein the gate source voltage of the PMOS transistor (CTP) corresponds to 0,5 times the supply voltage (VDD).

5. Electronic device comprising an integrated circuit according to any one of the claims 1 to 4.

**Amended claims in accordance with Rule 137(2) EPC.**

1. Integrated circuit, comprising:

an integrated circuit core unit (ICC), a plurality of input-output cells (IOC) coupled to the integrated circuit core unit (ICC) for protecting the core unit (ICC) from electrostatic discharges, a plurality of trigger units (TU), a first supply line (OVSS), a second supply line (OVDD), a first line (ESD_boost) coupled to the trigger unit (TU), a second line (ESD_trigger) coupled between a trigger unit (TU) and at least one of the input-output cells (IOC), wherein each input-output cell (IOC) is coupled between the first and second supply line (OVSS, OVDD) and comprises a clamp transistor unit (CTN, CTP) coupled between the first and second supply line (OVSS, OVDD), a third line (esd_trigger_pmos), wherein the clamp transistor unit (CTN, CTP) comprises a series arrangement of a NMOS transistor (CTN) and a PMOS transistor (CTP), wherein the trigger unit (TU) is coupled to the gate of the NMOS transistor (CTN) in the clamp transistor unit (CTN, CTP) via the second line (ESD_trigger), wherein the trigger unit (TU) is coupled to the gate of the PMOS transistor (CTP) in the clamp transistor unit (CTN, CTP) via the third line (esd_trigger_pmos), and wherein the trigger unit (TU) is arranged to trigger the clamp transistor unit (CTN, CTP) via the second and third line (ESD_trigger esd_trigger_pmos) if an electrostatic discharge event is detected on the first line (OVSS), wherein the drain of the NMOS transistor (CTN) is coupled to the second supply line (OVDD), the gate of the NMOS transistor (CTN) is coupled to ground, the drain of the PMOS transistor (CTP) is coupled to ground, and the gate of the PMOS transistor (CTP) is coupled to the second supply line (OVDD).

2. Integrated circuit according to claim 1, furthermore comprising:

a fourth line (esd_boost_pmos), which is coupled to the trigger unit (TU).

3. Integrated circuit according to any one of the claims 1 to 2, wherein the gate source voltage of the NMOS transistor (CTN) corresponds to -0,5 times the supply voltage (VDD), wherein the gate source voltage of the PMOS transistor (CTP) corresponds to 0,5 times the supply voltage (VDD).

4. Electronic device comprising an integrated circuit according to any one of the claims 1 to 3.

**Fig.1**

EP 2 244 292 A1

**Fig.2**

EP 2 244 292 A1

Fig.3

Fig.4

Fig.5

Europäisches
Patentamt

European
Patent Office

Office européen
des brevets

# EUROPEAN SEARCH REPORT

Application Number

EP 09 29 0291

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/076639 A1 (CHEN WEI-FAN [TW]) 24 April 2003 (2003-04-24) * paragraph [0031]; figure 7 * ----- | 1,2,4,5 | INV. H01L27/02 H03K19/003 |
| X | US 2004/223273 A1 (AUSTIN JAMES D [US] ET AL AUSTIN JAMES DUB [US] ET AL) 11 November 2004 (2004-11-11) * paragraph [0017] - paragraph [0025]; figures 4,5 * ----- | 1,2,4,5 | |
| X | MING-DOU KER ET AL: "Capacitor-Couple ESD Protection Circuit for Deep-Submicron Low-Voltage CMOS ASIC" IEEE TRANSACTIONS ON VERY LARGE SCALE INTEGRATION (VLSI) SYSTEMS, IEEE SERVICE CENTER, PISCATAWAY, NJ, US, vol. 4, no. 3, 1 September 1996 (1996-09-01), XP011063258 ISSN: 1063-8210 * figure 6 * ----- | 1,2,4,5 | |
| A | US 2008/151446 A1 (KER MING-DOU [TW] ET AL) 26 June 2008 (2008-06-26) * the whole document * ----- | 1-5 | TECHNICAL FIELDS SEARCHED (IPC) H01L H03K |

The present search report has been drawn up for all claims

| Place of search | Date of completion of the search | Examiner |
|---|---|---|
| Munich | 23 September 2009 | Santos, Paulo |

## ANNEX TO THE EUROPEAN SEARCH REPORT
## ON EUROPEAN PATENT APPLICATION NO.

EP 09 29 0291

This annex lists the patent family members relating to the patent documents cited in the above-mentioned European search report.
The members are as contained in the European Patent Office EDP file on
The European Patent Office is in no way liable for these particulars which are merely given for the purpose of information.

23-09-2009

| Patent document cited in search report | | Publication date | Patent family member(s) | | Publication date |
|---|---|---|---|---|---|
| US 2003076639 | A1 | 24-04-2003 | TW | 511271 B | 21-11-2002 |
| US 2004223273 | A1 | 11-11-2004 | NONE | | |
| US 2008151446 | A1 | 26-06-2008 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Michael Stockinger ; James W. Miller et al.** Boosted and distributed rail clamp networks for ESD protection in advanced CMOS technologies. *Proc. of EOS/ESD Symposium,* 2003